# EUROPEAN PATENT APPLICATION

(11) **EP 4 800 765 A1**
(43) Date of publication of application: **02.09.2026**
(21) Application number: 24882829.5
(22) Date of filing: 23.10.2024
(51) Int. Cl.: H01M 4/38, H01M 4/134, H01M 10/052, C30B 29/06, H01M 4/02

(54) **ANODE ACTIVE MATERIAL FOR LITHIUM SECONDARY BATTERY AND LITHIUM SECONDARY BATTERY COMPRISING SAME**

(30) Priority: 24.10.2023 KR 20230142833
(71) Applicant: Posco Future M Co., Ltd., Pohang-si, Gyeongsangbuk-do 37918 (KR)
(72) Inventor: LEE, Donggue, Pohang-si, Gyeongsangbuk-do 37918 (KR); LEE, Gaeul, Pohang-si, Gyeongsangbuk-do 37918 (KR); YOON, Hocheol, Pohang-si, Gyeongsangbuk-do 37918 (KR); JUNG, Jikwon, Pohang-si, Gyeongsangbuk-do 37918 (KR)
(74) Representative: Pfenning, Meinig & Partner mbB
(86) International application number: PCT/KR2024/016213
(87) International publication number: WO 2025/089802

(57) **Abstract**

The present invention relates to a negative electrode active material for a lithium secondary battery, which includes silicon particles having a single particle shape and a polycrystalline structure, wherein an average HS circularity is 0.875 or more, and the negative electrode active material satisfies Equation 1 below: ${Dv}_{1} \geq 2 μm$ where, in Equation 1, Dv₁ is a particle size corresponding to 1% of a cumulative volume in a particle size distribution curve of the silicon particles.

## Description

### [TECHNICAL FIELD]

The present invention relates to a negative electrode active material for a lithium secondary battery and a lithium secondary battery comprising the same.

### [BACKGROUND ART]

Lithium-ion batteries are currently the most widely used secondary battery systems, ranging from portable electronic communication devices and electric vehicles to energy storage systems. These lithium-ion batteries are a focus of interest as they have advantages such as high energy density, high operating voltage, and a relatively low self-discharge rate compared to commercial aqueous secondary batteries (Ni-Cd, Ni-MH, etc.).

However, considering more efficient use time in portable devices and improvement of energy characteristics in electric vehicles, improvements in electrochemical characteristics still remain as technical problems to be solved. For this reason, extensive research and development are currently being conducted on the four major raw materials: positive electrodes, negative electrodes, electrolytes, and separators.

Among these raw materials, graphite-based materials that exhibit excellent capacity retention characteristics and efficiency are commercialized for negative electrodes. However, the relatively low theoretical capacity value (LiC₆: 372 mAh/g) and low discharge capacity ratio of graphite-based materials are somewhat insufficient to meet the high energy and high power density characteristics of batteries required by the market.

Accordingly, many researchers are interested in Group 3 elements (Si, Ge, Sn) on the periodic table, and among them, Si, in particular, is attracting attention as a very attractive material due to its very high theoretical capacity (Li₁₅Si₄: 3600 mAh/g) and low operating voltage (~0.1 V vs. Li/Li⁺) characteristics.

However, general silicon-based negative electrode materials involve a volume change of up to 300% during cycling, and due to the generation of fine powder by particle cracks and loss of electrical contact caused by continuous charging and discharging, the discharge capacity ratio and cycle life characteristics are significantly deteriorated, making it difficult to apply them to actual batteries.

In particular, silicon-based negative electrode materials are manufactured by grinding silicon metal raw material powder, during which needle-like or flake-like silicon particles may be generated. Needle-like or flake-like silicon particles have poor lithium-ion reaction uniformity, causing non-uniform volume expansion during cycling and accelerating the pulverization of silicon particles, which further deteriorates the cycle life characteristics.

### [DETAILED DESCRIPTION OF THE INVENTION]

### [TECHNICAL PROBLEM]

Accordingly, an object of the present invention is to provide a silicon-based negative electrode active material with improved capacity and cycle life characteristics and a lithium secondary battery comprising the same by precisely controlling the grinding process during the production of silicon particles to reduce needle-like or flake-like silicon particles.

### [TECHNICAL SOLUTION]

One embodiment of the present invention provides a negative electrode active material for a lithium secondary battery, comprising silicon particles having a single particle shape and a polycrystalline structure, wherein an average HS circularity is 0.875 or more and satisfies Equation 1 below. ${Dv}_{1} \geq 2 μm$

In Equation 1, Dv₁ is a particle size corresponding to 1% of a cumulative volume in a particle size distribution curve of the silicon particles.

The silicon particles may have an average aspect ratio of 0.695 or more.

The silicon particles may satisfy Equation 2 below. $0.70 \leq \left[{Dv}_{50}-{Dv}_{10}\right] / \left[{Dv}_{90}-{Dv}_{50}\right] \leq 0.80$

In Equation 1, Dv₅₀ is a particle size corresponding to 50% of the cumulative volume in the particle size distribution curve of the silicon particles, Dv₁₀ is a particle size corresponding to 10% of the cumulative volume in the particle size distribution curve, and Dv₉₀ is a particle size corresponding to 90% of the cumulative volume in the particle size distribution curve.

The silicon particles may satisfy Equation 3 below. ${Dv}_{90} \leq 10 μm$

In Equation 3, Dv₉₀ is a particle size corresponding to 90% of the cumulative volume in the particle size distribution curve of the silicon particles.

The silicon particles may satisfy Equation 4 below. $\left[{Dv}_{90}-{Dv}_{10}\right] / {Dv}_{50} \leq 1.1$

In Equation 4, Dv₅₀ is a particle size corresponding to 50% of the cumulative volume in the particle size distribution curve of the silicon particles, Dv₁₀ is a particle size corresponding to 10% of the cumulative volume in the particle size distribution curve, and Dv₉₀ is a particle size corresponding to 90% of the cumulative volume in the particle size distribution curve.

A volume average particle diameter (Dv₅₀) of the silicon particles may be 4 µm to 6 µm.

An average grain size of the silicon particles may be 200 nm or less.

A Si purity of the silicon particles may be 98% or more.

Another embodiment of the present invention provides a negative electrode for a lithium secondary battery, comprising the aforementioned negative electrode active material.

Still another embodiment of the present invention provides a lithium secondary battery comprising the negative electrode for a lithium secondary battery.

### [ADVANTAGEOUS EFFECTS OF THE INVENTION]

A negative electrode active material for a lithium secondary battery according to an embodiment of the present invention includes silicon particles, in which needle-like or flake-like silicon particles are reduced and the particle size distribution is controlled, thereby achieving excellent capacity and cycle life characteristics.

### [BRIEF DESCRIPTION OF THE DRAWINGS]

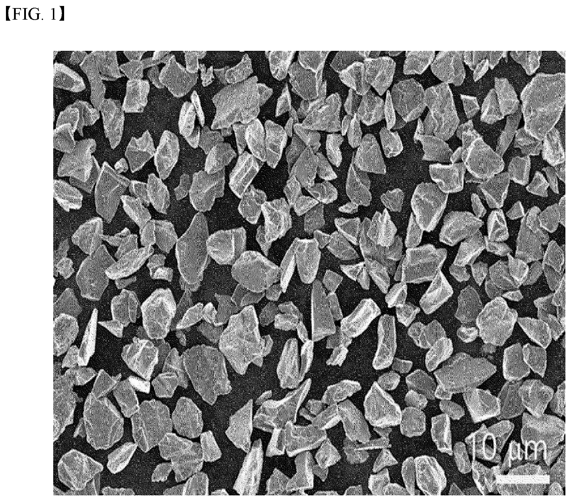

FIG. 1 is a SEM image of a negative electrode active material manufactured according to Example 1.

### [DETAILED DESCRIPTION OF THE EMBODIMENTS]

Terms such as first, second, and third are used to describe various parts, components, regions, layers, and/or sections, but are not limited thereto. These terms are used only to distinguish one part, component, region, layer, or section from another part, component, region, layer, or section. Accordingly, a first part, component, region, layer, or section described below may be referred to as a second part, component, region, layer, or section without departing from the scope of the present invention.

The terminology used herein is for the purpose of referring to specific embodiments only and is not intended to limit the present invention. The singular forms used herein include the plural forms as well, unless the phrases clearly indicate the opposite. The meaning of "comprising, including, and/or containing" used in the specification specifies a particular characteristic, region, integer, step, operation, element, and/or component, and does not exclude the presence or addition of other characteristics, regions, integers, steps, operations, elements, and/or components.

When a part is referred to as being "on" or "above/over" another part, it may be directly on or over the other part, or another part may be involved therebetween. In contrast, when a part is referred to as being "directly on" another part, no other part is interposed therebetween.

Unless otherwise defined, all terms including technical and scientific terms used herein have the same meaning as commonly understood by one of ordinary skill in the art to which the present invention belongs. Terms defined in commonly used dictionaries are further interpreted to have meanings consistent with the relevant technical literature and the presently disclosed content, and are not interpreted in an ideal or very formal sense unless defined.

In addition, unless otherwise specified, % means wt%, and 1 ppm is 0.0001 wt%.

In the present specification, the term "combination(s) thereof" described in the Markush format expression means one or more mixtures or combinations selected from the group consisting of the components described in the Markush format expression, and means including any one or more selected from the group consisting of the components.

Hereinafter, embodiments of the present invention will be described in detail so that those of ordinary skill in the art to which the present invention belongs can easily carry out the present invention. However, the present invention may be implemented in many different forms and is not limited to the embodiments described herein.

### 1. Negative Electrode Active Material

A negative electrode active material for a lithium secondary battery according to an embodiment of the present invention includes silicon particles. Since the negative electrode active material for a lithium secondary battery according to the present invention includes silicon particles, significantly higher capacity characteristics can be implemented compared to carbon-based negative electrode active materials commonly used in the prior art.

Specifically, the Si purity of the silicon particles may be 98% or more, and more specifically, 99% or 99.5% or more.

In addition, the silicon particles may have a single particle shape. That is, the silicon particles may have a single particle shape composed of one primary particle, rather than a secondary particle formed by agglomeration of a plurality of primary particles. Since the silicon particles are single particles, there may be an advantage of uniform particle size distribution. Meanwhile, "primary particle" refers to the minimum particle unit distinguished as a single lump when observing a cross-section of the negative electrode active material through a scanning electron microscope (SEM), and may be composed of one grain or a plurality of grains. In addition, "grain" refers to a distinct region in which atoms within a primary particle form a lattice structure in a certain direction.

In addition, the silicon particles may have a polycrystalline structure. Since the silicon particles are polycrystalline, there may be an advantage of improved cycle life. Meanwhile, the polycrystalline structure of the silicon particles can be confirmed by calculating the grain size through X-ray diffraction pattern analysis (XRD).

However, in the case of a general silicon negative electrode material, it involves a volume change of up to 300% during cycling, and due to the generation of fine powder by particle cracks and loss of electrical contact caused by continuous charging and discharging, the discharge capacity ratio and cycle life characteristics are significantly deteriorated, making it difficult to apply them to actual batteries.

In addition, silicon-based negative electrode materials are manufactured by grinding silicon metal raw material powder, and at this time, needle-like or flake-like silicon particles may be generated during the grinding process. Needle-like or flake-like silicon particles have poor lithium-ion reaction uniformity, so non-uniform volume expansion occurs during cycling, and pulverization of the silicon particles is accelerated, resulting in a problem of further deteriorating cycle life characteristics.

Furthermore, if the grinding process conditions are not precisely controlled, the fine powder of the silicon particles increases too much, which may deteriorate cycle life characteristics.

Accordingly, in the negative electrode active material for a lithium secondary battery according to an embodiment of the present invention, the grinding process conditions are precisely controlled as described in the manufacturing method described below (specific grinding process conditions will be described later). Accordingly, needle-like or flake-like silicon particles are reduced, and fine particles can be decreased. The reduction of needle-like or flake-like silicon particles and fine particles improves lithium-ion reaction uniformity and suppresses non-uniform volume expansion during cycling, thereby minimizing pulverization of the silicon particles. In addition, the reduction of fine particles can improve capacity and cycle life characteristics. As a result, the negative electrode active material for a lithium secondary battery according to the present invention can achieve good battery capacity and cycle life characteristics.

Specifically, the negative electrode active material for a lithium secondary battery according to an embodiment of the present invention has an average HS circularity of 0.875 or more, and more specifically, may be 0.89 or 0.9 or more. The improvement in the average HS circularity of the negative electrode active material can represent a degree to which needle-like or flake-like silicon particles are small. Therefore, as the average HS circularity of the negative electrode active material satisfies the above range, the capacity and cycle life characteristics of the battery can be well implemented.

Meanwhile, in the present specification, the average HS (High Sensitivity) circularity of the negative electrode active material can be obtained by deriving an average value of the HS circularity for 10,000 particles having a solidity value exceeding 0.96 among silicon particles. At this time, the "solidity value" is a value obtained by dividing the actual area of the particle by the area of the region surrounded by the particle envelope. By measuring the HS circularity only for silicon particles having a solidity value in the above range, the circularity can be measured only for silicon particles in a single particle form that do not overlap or agglomerate with each other. Accordingly, the circularity of the particles can be measured more precisely. Meanwhile, the measurement of the HS circularity of individual silicon particles can be obtained through Relationship 1 below. $HS Circularity = \frac{4 \times π \times Area}{{Perimeter}^{2}}$

In Relationship 1, "Area" refers to the total area of the particle derived as an individual 2D image for each particle through an image analysis device, and "Perimeter" refers to the total perimeter length of the particle derived as an individual 2D image for each particle through the image analysis device. Such circularity may be measured using an analyzer for obtaining optical images (Morphologi 4, Malvern Panalytical).

In addition, a negative electrode active material for a lithium secondary battery according to an embodiment of the present invention satisfies Equation 1 below. [Equation 1] Dv₁ ≥ 2 µm In Equation 1, Dv₁ is a particle diameter corresponding to 1% of a cumulative volume in a particle size distribution curve of the silicon particles. As the silicon particles satisfy Equation 1, the ratio of fine powder having an excessively small particle diameter decreases, whereby capacity, cycle life characteristics, and tap density can be improved.

More specifically, the Dv₁ value may be 2.2 µm or more, or 2.4 µm or more.

In addition, the silicon particles may have an average aspect ratio of 0.695 or more, and more specifically, 0.74 or more, or 0.75 or more. When the average aspect ratio of the silicon particles satisfies the above range, the particles react uniformly with lithium ions, resulting in uniform volume expansion, so that capacity and cycle life characteristics can be more preferably implemented. Meanwhile, in the present specification, "aspect ratio" may refer to a ratio of a length of a shortest side to a longest side in a silicon particle. At this time, the "average aspect ratio" can be obtained by calculating an average of aspect ratios measured for 50 random silicon particles observed on a scanning electron microscope (SEM) image. Such an aspect ratio may be measured using an analyzer for obtaining optical images (Morphologi 4, Malvern Panalytical).

Meanwhile, the silicon particles may satisfy Equation 2 below. $0.70 \leq \left[{Dv}_{50}-{Dv}_{10}\right] / \left[{Dv}_{90}-{Dv}_{50}\right] \leq 0.80$

In Equation 2, Dv₅₀ is a particle diameter corresponding to 50% of a cumulative volume in the particle size distribution curve of the silicon particles, Dv₁₀ is a particle diameter corresponding to 10% of the cumulative volume in the particle size distribution curve, and Dv₉₀ is a particle diameter corresponding to 90% of the cumulative volume in the particle size distribution curve. The Dv₅₀, Dv₉₀, and Dv₁₀ can be measured, for example, using a laser diffraction method. The laser diffraction method generally enables measurement of particle diameters ranging from a submicron region to several millimeters, and can yield results with high reproducibility and high resolution. As a laser diffraction analysis equipment, Shimadzu's SALD-2300 equipment may be used, and ethanol may be used as a solvent for particle size analysis. As the silicon particles satisfy Equation 2, the capacity, initial efficiency, and cycle life characteristics of the battery can be excellently improved.

More specifically, the value of [Dv₅₀ - Dv₁₀] / [Dv₉₀ - Dv₅₀] can represent the ratio of fine powder (fines) to coarse particles among a plurality of silicon particle powders. A smaller [Dv₅₀ - Dv₁₀] / [Dv₉₀ - Dv₅₀] value means a lower ratio of fine powder to coarse particles, and a larger [Dv₅₀ - Dv₁₀] / [Dv₉₀ - Dv₅₀] value may mean a higher ratio of fine powder to coarse particles. At this time, if the [Dv₅₀ - Dv₁₀] / [Dv₉₀ - Dv₅₀] value is too large, it means the ratio of fine powder is too high, which may cause problems such as gas generation due to side reactions with the electrolyte and loss of electrical contact, thereby deteriorating cycle life characteristics.

If the [Dv₅₀ - Dv₁₀] / [Dv₉₀ - Dv₅₀] value is too small, it means the ratio of coarse particles is too high, which may rather deteriorate cycle life characteristics due to an increase in the volume expansion rate. In addition, the present inventors have confirmed through experiments that as the silicon particles according to the present invention satisfy Equation 2, not only cycle life characteristics but also capacity and initial efficiency are improved. This is believed to be because the silicon particles uniformly participate in the electrochemical reaction due to the optimal ratio of fine powder and coarse particles.

The silicon particles may satisfy Equation 3 below. ${Dv}_{90} \leq 10 μm$

In Equation 3, Dv₉₀ is a particle diameter corresponding to 90% of the cumulative volume in the particle size distribution curve of the silicon particles. As the silicon particles satisfy Equation 3, the ratio of coarse particles having an excessively large particle diameter can be reduced. A large amount of coarse particles may generate a large amount of fine powder due to cracking according to continuous contraction and expansion as charging and discharging are repeated, and the migration length of lithium ions within the silicon particles may become longer, causing deterioration in capacity or initial efficiency. Therefore, as the ratio of coarse particles is reduced, the rate of fine powder generation due to repeated charging and discharging is reduced, thereby improving cycle life characteristics. In addition, by reducing the migration length of lithium ions within the silicon particles, capacity and initial efficiency can be improved. The Dv₉₀ may more specifically be 9 µm, 8 µm, or 7.7 µm or less.

The silicon particles may satisfy Equation 4 below. $\left[{Dv}_{90}-{Dv}_{10}\right] / {Dv}_{50} \leq 1.1$

In Equation 4, Dv₅₀ is a particle diameter corresponding to 50% of the cumulative volume in the particle size distribution curve of the silicon particles, Dv₁₀ is a particle diameter corresponding to 10% of the cumulative volume in the particle size distribution curve, and Dv₉₀ is a particle diameter corresponding to 90% of the cumulative volume in the particle size distribution curve. If the [Dv₉₀ - Dv₁₀] / Dv₅₀ value of the silicon particles is too large, it means that the particle size distribution of the particles becomes too wide, which may lead to problems of deterioration in cycle life characteristics due to a large amount of coarse and fine powder.

The volume average particle diameter (Dv₅₀) of the silicon particles may be 4 µm to 6 µm. If the volume average particle diameter of the silicon particles is too small, the specific surface area increases, which may cause problems of decreased efficiency and deteriorated cycle life characteristics. If the volume average particle diameter of the silicon particles is too large, pulverization is accelerated, which may cause a problem of deteriorated cycle life characteristics.

The tap density of the silicon particles may be 0.9 g/cm³ or more, and more specifically, 1.0 g/cm³ or 1.04 g/cm³ or more. As the tap density of the silicon particles is sufficiently high, the electrode energy density can be improved. The tap density of the silicon particles can be measured by a method commonly used in the art as a method for measuring a degree of filling of a sample per unit volume. For example, it may be a density (sample weight/volume) calculated through a change in volume after mechanically tapping a measuring container containing a sample a predetermined number of times at a constant height in accordance with the measuring equipment and method specified in ASTM B527.

The BET specific surface area of the silicon particles may be 1.4 m²/g to 2.2 m²/g. If the specific surface area of the silicon particles is too small, it means there are too many coarse particles, whereby capacity, initial efficiency, and cycle life characteristics may be deteriorated. If the specific surface area of the silicon particles is too large, it means there is too much fine powder, whereby capacity, initial efficiency, and cycle life characteristics may be deteriorated. The BET specific surface area can be measured using the BET method (Surface area and Porosity analyzer) (Micromeritics, ASAP2020).

In addition, the average grain size of the silicon particles may be 200 nm or less, more specifically, 180 nm or 160 nm or less, and 140 nm or 145 nm or more. Since the average grain size of the silicon particles is sufficiently small as described above, the degree of volume expansion and contraction during charging and discharging is reduced, so that the cycle life characteristics of the battery can be improved. However, if the grain size of the silicon particles is too small, the particles may be broken due to excessive processing, or the pattern of volume change during charging and discharging may vary. In the present specification, the grain size of the silicon particles can be measured by analyzing X-ray diffraction data of a cross-section of the active material using a Rietveld refinement method. For example, the grain size can be obtained by performing X-ray diffraction analysis using Bruker's D8 Discover with GADDS XRD equipment under the following conditions to obtain XRD data, and then processing the XRD data using Bruker's DIFFRAC.TOPAS program. At this time, the full width at half maximum (FWHM) was set to be measured using the Caglioti equation.

### <X-ray Diffraction Analysis Conditions>

Light source: Cu-target, 45 kV, 40 mA output, wavelength = 1.54 Å
Detector: GaliPIX3D
Sample preparation: Approximately 2 g of sample was filled into a holder with a diameter of 2 cm and loaded onto a rotation stage.
Measurement time: Approximately 20 minutes
Measurement range: 2θ = 10° to 90°

In addition, the strain of the silicon particles may be 10 × 10⁻⁵ or more, more specifically, 10.5 × 10⁻⁵ or 11.7 × 10⁻⁵ or more, and 13 × 10⁻⁵ or less or 12.5 × 10⁻⁵ or less. As the strain of the silicon particles is sufficiently large as described above, the cycle life characteristics of the battery can be improved. However, if the strain of the silicon particles is too large, the internal stress of the particles increases, making them vulnerable to impact, and pulverization of the particles may rapidly progress due to volume expansion during charging, whereby electrode deterioration may occur quickly. In the present specification, strain is a value measured through Rietveld refinement analysis of X-ray diffraction data, representing an average deviation of the lattice spacing d and indicating a degree of deformation of the crystal lattice, and satisfies the following equation. ${ε}_{0} = \frac{Δ d}{d} = \frac{{β}_{FWHM \left(str\right)}}{4 tan θ}$

Here, *β*_{*FWHM*(*str*)} represents the full width at half maximum (FWHM) of a profile component associated with micro-strain broadening.

### 2. Method for Manufacturing Negative Electrode Active Material

Various physical properties of the silicon particles according to the present invention, including the aforementioned HS circularity, Dv₁ value, average aspect ratio, and [Dv₅₀ - Dv₁₀] / [Dv₉₀ - Dv₅₀] value, can be appropriately obtained within the ranges according to the present invention when manufactured according to the following series of manufacturing methods.

Hereinafter, a method for manufacturing a negative electrode active material for a lithium secondary battery according to another embodiment of the present invention will be described.

A method for manufacturing a negative electrode active material for a lithium secondary battery according to another embodiment of the present invention may include: performing first grinding of metallurgical silicon powder; performing second grinding of the first-ground metallurgical silicon powder; performing first classification of the second-ground metallurgical silicon powder; performing third grinding of the first-classified metallurgical silicon powder; and performing second classification of the third-ground metallurgical silicon powder. Hereinafter, each step will be described in more detail.

First, metallurgical silicon powder is subjected to first grinding. In this case, the metallurgical silicon powder may include 98% or more of silicon and other unavoidable impurities based on the total weight. The first grinding may be performed using equipment commonly used in the art and is not particularly limited. For example, the first grinding may be performed using a rotary cutter mill, but is not limited thereto. In this case, the first grinding may be performed such that a volume-based particle diameter (Dv₉₀) of the metallurgical silicon powder is 4 mm or less. Accordingly, grinding efficiency in a subsequent second grinding process can be increased, and coarse particles having an excessively large particle diameter can be primarily removed.

Next, the first-ground metallurgical silicon powder is subjected to second grinding. The second grinding may be performed using equipment commonly used in the art and is not particularly limited. For example, the second grinding may be performed using at least one selected from a jet mill, a ball mill, a stirred media mill, a roll mill, a hammer mill, a pin mill, a disk mill, a colloid mill, and an atomizer mill, but is not limited thereto. In this case, the second grinding may be performed such that a volume-based particle diameter (Dv₃₀) of the metallurgical silicon powder is 150 µm or more. Accordingly, it is possible to prevent the generation of a large amount of fine powder to ultra-fine powder in a subsequent third grinding process. More specifically, by removing metallurgical silicon powder having an excessively small volume-based particle diameter (Dv₃₀) during the second grinding, collisions between particles of an appropriate particle diameter can be induced in the subsequent third grinding process, thereby preventing the generation of a large amount of fine powder to ultra-fine powder in a final product. Accordingly, the Dv₁ value, average HS circularity, average aspect ratio, and [Dv₅₀ - Dv₁₀] / [Dv₉₀ - Dv₅₀] value of the silicon particles, which are the final product, can be appropriately obtained within the ranges according to the present invention.

Next, the second-ground metallurgical silicon powder is subjected to first classification. The first classification may be performed, for example, through mesh classification, but is not necessarily limited thereto. In this case, the first classification may be performed to remove metallurgical silicon powder having a particle diameter of less than 100 µm. Accordingly, grinding efficiency in the subsequent third grinding process can be improved, and the fine powder generation rate in the final product can be reduced. An upper limit of the particle diameter of the metallurgical silicon powder to be removed can be set, for example, by appropriately adjusting a perforation diameter of a mesh screen. Accordingly, the Dv₁ value, average HS circularity, average aspect ratio, and [Dv₅₀ - Dv₁₀] / [Dv₉₀ - Dv₅₀] value of the silicon particles, which are the final product, can be appropriately obtained within the ranges according to the present invention.

Next, the first-classified metallurgical silicon powder is subjected to third grinding. The third grinding may be performed using grinding equipment commonly used in the art and is not particularly limited. For example, the third grinding may be performed using at least one selected from a jet mill, a spiral jet mill, a ball mill, a stirred media mill, a roll mill, a hammer mill, a pin mill, a disk mill, a colloid mill, and an atomizer mill, but is not limited thereto. In this case, the third grinding may be performed such that an average particle diameter (Dv₅₀) of the metallurgical silicon powder is 4 µm to 6 µm. Accordingly, the average particle diameter (Dv₅₀) of the final product can be appropriately obtained within the range according to the present invention.

Next, the third-ground metallurgical silicon powder is subjected to second classification. The second classification may use, for example, any one of a gravity type, an inertial type, and a centrifugal type, but is not necessarily limited thereto. In this case, the second classification may be controlled such that a yield of the metallurgical silicon powder (the final product) satisfying a SPAN ((Dv₉₀ - Dv₁₀) / Dv₅₀) value of 1 or less is 30% to 40% based on a total weight of the metallurgical silicon powder as a starting raw material, and more specifically, 32% to 38%. Accordingly, the Dv₁ value, average HS circularity, average aspect ratio, and [Dv₅₀ - Dv₁₀] / [Dv₉₀ - Dv₅₀] value of the silicon particles, which are the final product, can be appropriately obtained within the ranges according to the present invention. In the present specification, the SPAN value refers to a value derived by calculating [particle diameter (Dv₉₀) - particle diameter (Dv₁₀)] / particle diameter (Dv₅₀). In this case, particle diameter (Dv₉₀), particle diameter (Dv₁₀), and particle diameter (Dv₅₀) may be defined as particle diameters corresponding to 90%, 10%, and 50% of a cumulative volume, respectively, in a particle size distribution curve of particles. More specifically, the second classification may include: removing fine powder from the third-ground metallurgical silicon powder; and removing coarse particles from the third-ground metallurgical silicon powder. In the removing of the fine powder, fine powder having a particle diameter of 0.5 µm or less may be removed, and in the removing of the coarse particles, coarse particles having a particle diameter of 25 µm or more may be removed.

Through the series of processes described above, the negative electrode active material for a lithium secondary battery according to the present invention can be manufactured, and various physical properties such as HS circularity, Dv₁ value, average aspect ratio, and [Dv₅₀ - Dv₁₀] / [Dv₉₀ - Dv₅₀] value can be appropriately obtained within the ranges according to the present invention. Accordingly, the capacity, initial efficiency, and cycle life characteristics of the battery can be uniformly improved.

### 3. Negative Electrode and Lithium Secondary Battery

Another embodiment of the present invention provides a negative electrode comprising the aforementioned negative electrode active material and a lithium secondary battery comprising the same.

A negative electrode for a lithium secondary battery according to another embodiment of the present invention may more specifically include: a negative electrode current collector; and a negative electrode active material layer positioned on the negative electrode current collector and comprising the aforementioned negative electrode active material for a lithium secondary battery.

The negative electrode current collector is not particularly limited as long as it possesses high conductivity without causing chemical changes in the battery, and for example, copper, stainless steel, aluminum, nickel, titanium, sintered carbon, copper or stainless steel surface-treated with carbon, nickel, titanium, silver, etc., an aluminum-cadmium alloy, and the like may be used. In addition, the negative electrode current collector may typically have a thickness of 3 µm to 500 µm, and similar to a positive electrode current collector, fine irregularities may be formed on a surface of the current collector to enhance a binding force of the negative electrode active material. For example, it may be used in various forms such as a film, a sheet, a foil, a net, a porous body, a foam, and a non-woven fabric.

The negative electrode active material layer may optionally include a binder and/or a conductive material along with the negative electrode active material. The binder serves to improve adhesion between the negative electrode active material particles and adhesion between the negative electrode active material and the negative electrode current collector. Specific examples include polyvinylidene fluoride (PVDF), vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, ethylene-propylene-diene monomer rubber (EPDM rubber), sulfonated-EPDM, styrene-butadiene rubber (SBR), fluororubber, or various copolymers thereof, and mixtures of one or more of these may be used. The binder may be included in an amount of 1 wt% to 30 wt% based on a total weight of the negative electrode active material layer.

The conductive material is used to impart conductivity to an electrode and can be used without particular limitation as long as it possesses electronic conductivity without causing chemical changes in a configured battery. Specific examples include graphite such as natural graphite or artificial graphite; carbon-based materials such as carbon black, acetylene black, ketjen black, channel black, furnace black, lamp black, thermal black, and carbon fiber; metal powders or metal fibers such as copper, nickel, aluminum, and silver; conductive whiskers such as zinc oxide and potassium titanate; conductive metal oxides such as titanium oxide; or conductive polymers such as polyphenylene derivatives, and mixtures of one or more of these may be used. The conductive material may typically be included in an amount of 1 wt% to 30 wt% based on the total weight of the negative electrode active material layer.

The negative electrode for a lithium secondary battery according to an embodiment of the present invention may be manufactured according to a conventional negative electrode manufacturing method, except for using the aforementioned negative electrode active material. Specifically, it may be manufactured by applying a composition for forming a negative electrode active material layer, which comprises the aforementioned negative electrode active material and optionally a binder, a conductive material, and a solvent, onto the negative electrode current collector, followed by rolling and drying. In this case, types and contents of the negative electrode active material, the binder, and the conductive material are as described above. The solvent may be a solvent commonly used in the art, such as dimethylsulfoxide (DMSO), isopropyl alcohol, N-methylpyrrolidone (NMP), acetone, or water, and mixtures of one or more of these may be used. An amount of the solvent used is sufficient as long as it dissolves or disperses the negative electrode active material, the conductive material, and the binder, considering a coating thickness of a slurry and a manufacturing yield, and possesses a viscosity capable of exhibiting excellent thickness uniformity during coating for subsequent negative electrode manufacturing.

As another method, the negative electrode may be manufactured by casting the composition for forming the negative electrode active material layer onto a separate support and then laminating a film obtained by peeling from the support onto the negative electrode current collector.

Another embodiment of the present invention provides a lithium secondary battery comprising the aforementioned negative electrode for a lithium secondary battery. The lithium secondary battery may more specifically include a positive electrode, a negative electrode positioned opposite the positive electrode, a separator interposed between the positive electrode and the negative electrode, and an electrolyte. Materials generally used in the art may be used without limitation for the positive electrode, the separator, and the electrolyte, other than the negative electrode.

### EXAMPLES

Hereinafter, embodiments of the present invention will be described in more detail through examples. However, the following examples are only preferred embodiments of the present invention, and the present invention is not limited by the following examples.

### Example 1

### (1) Manufacture of Negative Electrode Active Material

(First Grinding) Metallurgical silicon powder having a purity of 98% was subjected to first grinding using rotary cutter mill equipment. In this case, process conditions were adjusted to form metallurgical silicon powder having a volume-based particle diameter (Dv₉₀) of 4 mm or less.

(Second Grinding) Thereafter, the metallurgical silicon powder was subjected to second grinding using disk mill equipment. In this case, a disk interval was adjusted to form metallurgical silicon powder having a volume-based particle diameter (Dv₃₀) of 200 µm or more.

(First Classification) Thereafter, the metallurgical silicon powder was subjected to first classification by a mesh classification method. In this case, a 200 mesh was used to remove metallurgical silicon powder having a particle diameter of less than 100 µm.

(Third Grinding) Thereafter, the metallurgical silicon powder was subjected to third grinding using jet mill equipment. In this case, a jet pressure (6 bar or more) and a raw material feeding rate were adjusted so that a volume-based average particle diameter (Dv₅₀) was 4 µm to 6 µm. In this case, optimal conditions for the jet pressure and the feeding rate may vary depending on specifications of the jet mill.

(Second Classification) Thereafter, the metallurgical silicon powder was subjected to second classification by an air classification method. In this case, coarse particles having a particle diameter of 25 µm or more and fine powder having a particle diameter of 0.5 µm or less were removed through the air classification. Through this, a yield of silicon particles (final product) satisfying a SPAN ((Dv₉₀ - Dv₁₀) / Dv₅₀) value of 1 or less was controlled to be 35% based on a total weight of the metallurgical silicon powder as a starting raw material.

### (2) Manufacture of Negative Electrode

The manufactured negative electrode active material, a conductive material, styrene-butadiene rubber (SBR) as a binder, and carboxymethyl cellulose (CMC) as a thickener were mixed in a mass ratio of 96:1:1.5:1.5 and then dispersed in deionized water to prepare a negative electrode active material layer composition. The composition was applied to a Cu-foil current collector, dried, and rolled to manufacture a negative electrode having an electrode density of 1.40 ± 0.05 g/cm³.

### (3) Manufacture of Lithium Secondary Battery

A coin-type 2032 half-cell was manufactured using the negative electrode as a working electrode and metallic lithium as a counter electrode. In this case, a separator composed of a porous polypropylene film was inserted between the working electrode and the counter electrode, and as an electrolyte, a solution in which 1M concentration of LiPF₆ was dissolved in a mixed solution of fluoroethylene carbonate (FEC) and ethyl methyl carbonate (EMC) at a mixing volume ratio of 3:7 was used.

### Example 2

A negative electrode active material, a negative electrode, and a lithium secondary battery were manufactured in the same manner as in Example 1, except that a 270 mesh was used to remove metallurgical silicon powder having a particle diameter of less than 70 µm in the first classification step.

### Example 3

A negative electrode active material, a negative electrode, and a lithium secondary battery were manufactured in the same manner as in Example 1, except that a 325 mesh was used to remove metallurgical silicon powder having a particle diameter of less than 50 µm in the first classification step.

### Example 4

A negative electrode active material, a negative electrode, and a lithium secondary battery were manufactured in the same manner as in Example 1, except that the disk interval was adjusted to form metallurgical silicon powder having a volume-based particle diameter (Dv₃₀) of 150 µm or more in the second grinding step.

### Comparative Example 1

A negative electrode active material, a negative electrode, and a lithium secondary battery were manufactured in the same manner as in Example 1, except that the first classification step was not performed.

### Comparative Example 2

A negative electrode active material, a negative electrode, and a lithium secondary battery were manufactured in the same manner as in Example 1, except that in the second classification step, a fine powder control classification wheel speed was accelerated to partially increase a content of fine powder, so that a yield with a SPAN value of 1 or less was about 41%.

### Comparative Example 3

A negative electrode active material, a negative electrode, and a lithium secondary battery were manufactured in the same manner as in Example 1, except that in the second grinding step, a grinding intensity was strongly adjusted to form metallurgical silicon powder having a volume-based particle diameter (Dv₃₀) of 100 µm or less, and the first classification step was not performed.

### Comparative Example 4

A negative electrode active material, a negative electrode, and a lithium secondary battery were manufactured in the same manner as in Example 1, except that the second classification step was not performed.

Table 1 below is a table summarizing the process conditions of the Examples and Comparative Examples.

**[Table 1]**

| | 1st Grinding | 2nd Grinding | 1st Classification | 3rd Grinding | 2nd Classification (=Product) |
|---|---|---|---|---|---|
| Ex. 1 | Dv90 ≤ 4mm | 200um ≤ Dv30 | Removal of less than 100µm (200 mesh) | Dv50 4~6um | Yield of 35% with SPAN of 1 or less |
| Ex. 2 | Dv90 ≤ 4mm | 200um ≤ Dv30 | Removal of less than 70µm (270 mesh) | Dv50 4~6um | Same as Example 1 |
| Ex. 3 | Dv90 ≤ 4mm | 200um ≤ Dv30 | Removal of less than 50µm (325 mesh) | Dv50 4~6um | Same as Example 1 |
| Ex. 4 | Dv90 ≤ 4mm | 150um ≤ Dv30 | Removal of less than 100µm (200 mesh) | Dv50 4~6um | Same as Example 1 |
| C-Ex. 1 | Dv90 ≤ 4mm | 200um ≤ Dv30 | X | Dv50 4~6um | Same as Example 1 |
| C-Ex. 2 | Dv90 ≤ 4mm | 200um ≤ Dv30 | Removal of less than 100µm (200 mesh) | Dv50 4~6um | Yield of 41% with SPAN of 1 or less |
| C-Ex. 3 | Dv90 ≤ 4mm | Dv30 ≤ 100um | X | Dv50 4~6um | Same as Example 1 |
| C-Ex. 4 | Dv90 ≤ 4mm | 200um ≤ Dv30 | Removal of less than 100µm (200 mesh) | Dv50 4~6um | X |

### Experimental Example 1: Evaluation of SEM Images of Negative Electrode Active Material

SEM images of the negative electrode active material prepared according to Example 1 were evaluated and are shown in FIG. 1.

Referring to FIG. 1, it was confirmed that the negative electrode active material of Example 1 has a single particle shape. In addition, it was confirmed that needle-like or flake-like particles were not observed.

### Experimental Example 2: Evaluation of Physical Properties of Negative Electrode Active Material

### (1) Evaluation of volume-based particle diameters (Dv₁, Dv₁₀, Dv₅₀, Dv₉₀)

Volume-based particle diameters (Dv₁, Dv₁₀, Dv₅₀, Dv₉₀) were evaluated using a laser diffraction method. Dv₁, Dv₁₀, Dv₅₀, and Dv₉₀ can be defined as particle diameters corresponding to 1%, 10%, 50%, and 90% of a cumulative volume, respectively, in a particle size distribution curve of the particles. In this case, SALD-2300 equipment from Shimadzu was used as the laser diffraction analysis equipment, and ethanol was used as a solvent for particle size analysis.

### (2) Evaluation of average HS circularity

An average HS (High Sensitivity) circularity of the negative electrode active material was determined by deriving an average value of HS circularity for 10,000 particles having a solidity value exceeding 0.96 among the silicon particles. In this case, the "solidity value" is a value obtained by dividing an actual area of a particle by an area of a region surrounded by a particle envelope.

Meanwhile, the measurement of the HS circularity of individual silicon particles was obtained through Relationship 1 below. $HS Circularity = \frac{4 \times π \times Area}{{Perimeter}^{2}}$

In Relationship 1, Area refers to the total area of the particle derived as an individual 2D image for each particle through an image analysis device, and Perimeter refers to the total perimeter length of the particle derived as an individual 2D image for each particle through the image analysis device.

Such circularity was measured using an analyzer (Morphologi 4, Malvern Panalytical) for obtaining optical images.

### (3) Evaluation of average aspect ratio

The "average aspect ratio" can be obtained by calculating an average of aspect ratios measured for 50 random silicon particles observed on a scanning electron microscope (SEM) image. Such an aspect ratio may be measured using an analyzer (Morphologi 4, Malvern Panalytical) for obtaining optical images. In this case, "aspect ratio" may refer to a ratio of a length of a shortest side to a longest side in a silicon particle.

### (4) Evaluation of tap density

Based on ASTM-B527, 15 g of the active material powder was placed in a 25 mL cylinder, and then tapping was performed for 3,000 cycles at 284 cycles/min to measure a packing density.

### (5) Evaluation of BET specific surface area

The specific surface area was measured using a BET method (Surface area and Porosity analyzer) (ASAP2020, Micromeritics).

### (6) Evaluation of average grain size

XRD data of the active material was measured using a D8 Discover with GADDS XRD equipment from Bruker, and an average grain size (crystal size) was evaluated through a Rietveld refinement method built into the DIFFRAC.TOPAS program from Bruker.

**[Table 2]**

| | Dv1 (um) | Dv10 (um) | Dv50 (um) | Dv90 (um) | SPAN | [Dv50-Dv10]/ [Dv90-Dv50] |
|---|---|---|---|---|---|---|
| Ex. 1 | 2.55 | 3.37 | 5.15 | 7.57 | 0.82 | 0.73 |
| Ex. 2 | 2.42 | 3.15 | 4.96 | 7.41 | 0.86 | 0.74 |
| Ex. 3 | 2.23 | 3.00 | 4.82 | 7.31 | 0.89 | 0.73 |
| Ex. 4 | 2.22 | 2.87 | 4.80 | 7.30 | 0.92 | 0.77 |
| C-Ex. 1 | 2.28 | 3.14 | 5.06 | 7.49 | 0.86 | 0.82 |
| C-Ex. 2 | 1.99 | 2.78 | 4.99 | 7.21 | 0.89 | 0.94 |
| C-Ex. 3 | 1.78 | 2.69 | 4.86 | 7.32 | 0.95 | 0.82 |
| C-Ex. 4 | 0.70 | 1.75 | 4.28 | 7.17 | 1.27 | 0.88 |

**[Table 3]**

| | Average HS Circularity | Average Aspect Ratio | Tap Density (g/cc) | BET Specific Surface Area (m²/g) | Average Grain Size (nm) |
|---|---|---|---|---|---|
| Ex. 1 | 0.901 | 0.751 | 1.09 | 1.40 | 160 |
| Ex. 2 | 0.914 | 0.763 | 1.06 | 1.63 | 159 |
| Ex. 3 | 0.887 | 0.732 | 0.96 | 1.90 | 174 |
| Ex. 4 | 0.880 | 0.698 | 0.99 | 2.20 | 157 |
| C-Ex. 1 | 0.870 | 0.684 | 1.00 | 2.21 | 174 |
| C-Ex. 2 | 0.871 | 0.690 | 0.96 | 2.09 | 182 |
| C-Ex. 3 | 0.865 | 0.678 | 0.99 | 3.01 | 171 |
| C-Ex. 4 | 0.868 | 0.688 | 0.97 | 1.99 | 183 |

Referring to Tables 2 and 3, in the case of the negative electrode active materials of the Examples in which the process conditions were appropriately controlled according to the present invention, it was confirmed that various physical properties including the average HS circularity and the Dv₁ value were appropriately obtained within the ranges according to the present invention.

On the other hand, in the case of Comparative Example 1, as a result of not performing the first classification, it was confirmed that the average HS circularity and the average aspect ratio were somewhat decreased, and the [Dv₅₀ - Dv₁₀] / [Dv₉₀ - Dv₅₀] value was obtained excessively high.

In the case of Comparative Example 2, the classification wheel speed for fine powder control during the second classification was excessively accelerated, and as a result of the yield of a SPAN value of 1 or less being adjusted too high, the Dv₁ value was obtained small, the average HS circularity and the average aspect ratio were somewhat decreased, and the [Dv₅₀ - Dv₁₀] / [Dv₉₀ - Dv₅₀] value was obtained excessively high.

In the case of Comparative Example 3, as a result of adjusting Dv₃₀ to be too small during the second grinding and not performing the first classification, the Dv₁ value was obtained small, the average HS circularity and the average aspect ratio were further decreased compared to Comparative Example 1, and the [Dv₅₀ - Dv₁₀] / [Dv₉₀ - Dv₅₀] value was obtained excessively high.

In the case of Comparative Example 4, as a result of not performing the second classification, it was confirmed that the Dv₁ value was obtained very small, the average HS circularity and the average aspect ratio were decreased, and the [Dv₅₀ - Dv₁₀] / [Dv₉₀ - Dv₅₀] value was obtained excessively high.

At this time, in the case of Comparative Examples 1 to 3, the reason why the HS circularity is particularly deteriorated can be interpreted as a result of the process conditions not being appropriately controlled during the second grinding, the first classification, or the second classification, leading to an increased content of fine powder in the silicon particles introduced into the third grinding process, which in turn causes a large amount of needle-like or flake-like particles to be generated during the third grinding process.

In addition, in the case of Comparative Example 4, the reason why the HS circularity is particularly deteriorated can be interpreted as a result of the fine powder and coarse particles not being appropriately removed during the second classification process.

### Experimental Example 3: Evaluation of Electrochemical Characteristics of Lithium Secondary Battery

### (1) Evaluation of initial discharge capacity and initial efficiency

After fabricating CR2032 coin half-cells of a lithium secondary battery, they were aged at 25°C for 30 hours, and then a charge/discharge test was performed. For initial capacity evaluation, the standard capacity was set to 3,500 mAh/g, and charging was performed at a constant current of 0.1 C to 5 mV, followed by switching to a constant voltage and charging until the cut-off current reached 0.005 C. After a rest time of 10 minutes following charging, discharging was performed at a constant current of 0.1 C (based on 3,500 mAh/g) until the voltage reached 1.0 V.

### (2) Evaluation of cycle life characteristics

For the cycle life characteristics, charging was performed at 25°C at a constant current of 0.5 C to 5 mV, followed by switching to a constant voltage and charging until the cut-off current reached 0.005 C. After a rest time of 10 minutes following charging, discharging was performed at a constant current of 0.5 C until the voltage reached 1.0 V. Charging and discharging were performed 100 times under such charge/discharge conditions, and the capacity retention of the 100th cycle relative to the first cycle was calculated.

**[Table 4]**

| | Initial Capacity | Initial Efficiency | 100^{th} cycle |
|---|---|---|---|
| | (mAh/g) | (%) | retention (%) |
| Ex. 1 | 3626 | 93.1 | 94.6 |
| Ex. 2 | 3658 | 93 | 94.7 |
| Ex. 3 | 3558 | 93.6 | 94.3 |
| Ex. 4 | 3590 | 92.9 | 94.1 |
| C-Ex. 1 | 3528 | 91.8 | 93.9 |
| C-Ex. 2 | 3493 | 91.2 | 92.4 |
| C-Ex. 3 | 3465 | 91 | 91 |
| C-Ex. 4 | 3530 | 90.3 | 90.1 |

Referring to Table 4, in the case of the Examples where overall physical properties including the average HS circularity and Dv₁ value of the negative electrode active material satisfy the ranges according to the present invention, it was confirmed that the initial capacity, initial efficiency, and cycle life characteristics were all very excellent. On the other hand, in the case of Comparative Example 1, as the average HS circularity and the like were outside the ranges according to the present invention, it was confirmed that the initial capacity, initial efficiency, and cycle life characteristics were deteriorated compared to the Examples.

In addition, in the case of Comparative Examples 2 to 4, as the Dv₁ value and the average HS circularity were outside the ranges according to the present invention, it was confirmed that the initial capacity, initial efficiency, and cycle life characteristics were deteriorated compared to the Examples.

Meanwhile, comparing Examples 1 to 2 with Examples 3 to 4, it was confirmed that in the case of Examples 1 to 2 where the Dv₁ value, average HS circularity, or average aspect ratio was more controlled, the capacity, cycle life characteristics, and tap density (refer to Tables 3 and 4) were more preferably implemented compared to Examples 3 to 4.

While the preferred embodiments of the present invention have been described above, the present invention is not limited thereto, and various modifications and variations can be made within the scope of the claims, the detailed description, and the accompanying drawings, which also fall within the scope of the present invention.

Therefore, the substantial scope of the present invention will be defined by the appended claims and their equivalents.

## Claims

1. A negative electrode active material for a lithium secondary battery, comprising: silicon particles having a single particle shape and a polycrystalline structure, wherein the negative electrode active material has an average HS circularity of 0.875 or more and satisfies Equation 1 below: ${Dv}_{1} \geq 2 μm$ where, in Equation 1, Dv₁ is a particle size corresponding to 1% of a cumulative volume in a particle size distribution curve of the silicon particles.

2. The negative electrode active material for a lithium secondary battery of claim 1, wherein: the silicon particles have an average aspect ratio of 0.695 or more.

3. The negative electrode active material for a lithium secondary battery of claim 1, wherein: the silicon particles satisfy Equation 2 below: $0.70 \leq \left[{Dv}_{50}-{Dv}_{10}\right] / \left[{Dv}_{90}-{Dv}_{50}\right] \leq 0.80$ where, in Equation 2, Dv₅₀ is a particle size corresponding to 50% of a cumulative volume in the particle size distribution curve of the silicon particles, Dv₁₀ is a particle size corresponding to 10% of the cumulative volume in the particle size distribution curve, and Dv₉₀ is a particle size corresponding to 90% of the cumulative volume in the particle size distribution curve.

4. The negative electrode active material for a lithium secondary battery of claim 1, wherein: the silicon particles satisfy Equation 3 below: ${Dv}_{90} \leq 10 μm$ where, in Equation 3, Dv₉₀ is a particle size corresponding to 90% of a cumulative volume in the particle size distribution curve of the silicon particles.

5. The negative electrode active material for a lithium secondary battery of claim 1, wherein: the silicon particles satisfy Equation 4 below: $\left[{Dv}_{90}-{Dv}_{10}\right] / {Dv}_{50} \leq 1.1$ where, in Equation 4, Dv₅₀ is a particle size corresponding to 50% of a cumulative volume in the particle size distribution curve of the silicon particles, Dv₁₀ is a particle size corresponding to 10% of the cumulative volume in the particle size distribution curve, and Dv₉₀ is a particle size corresponding to 90% of the cumulative volume in the particle size distribution curve.

6. The negative electrode active material for a lithium secondary battery of claim 1, wherein: a volume average particle diameter (Dv₅₀) of the silicon particles is 4 µm to 6 µm.

7. The negative electrode active material for a lithium secondary battery of claim 1, wherein: an average grain size of the silicon particles is 200 nm or less.

8. The negative electrode active material for a lithium secondary battery of claim 1, wherein: a Si purity of the silicon particles is 98% or more.

9. A negative electrode for a lithium secondary battery, comprising: the negative electrode active material of any one of claims 1 to 8.

10. A lithium secondary battery, comprising: the negative electrode for a lithium secondary battery of claim 9.
